# EUROPEAN PATENT APPLICATION

(11) **EP 4 174 911 A1**
(43) Date of publication of application: **03.05.2023**
(21) Application number: 22185124.9
(22) Date of filing: 15.07.2022
(51) Int. Cl.: H01L 21/20, H01L 23/00

(54) **IC STRUCTURES WITH IMPROVED BONDING BETWEEN A SEMICONDUCTOR LAYER AND A NON-SEMICONDUCTOR SUPPORT STRUCTURE**

(30) Priority: 26.10.2021 US 202117510426
(71) Applicant: INTEL Corporation, Santa Clara, CA 95054 (US)
(72) Inventor: Gomes, Wilfred, Portland, 97229 (US); Sharma, Abhishek A., Hillsboro, 97124 (US)
(74) Representative: Goddar, Heinz J.

(57) **Abstract**

Embodiments of the present disclosure relate to methods of fabricating IC devices with IC structures with improved bonding between a semiconductor layer and a non-semiconductor support structure, as well as resulting IC devices, assemblies, and systems. An example method includes providing a semiconductor material over a semiconductor support structure and, subsequently, depositing a first bonding material on the semiconductor material. The method further includes depositing a second bonding material on a non-semiconductor support structure such as glass or mica wafers, followed by bonding the face of the semiconductor material with the first bonding material to the face of the non-semiconductor support structure with the second bonding material. Using first and second bonding materials that include silicon, nitrogen, and oxygen (e.g., silicon oxynitride or carbon-doped silicon oxynitride) may significantly improve bonding between semiconductor layers and non-semiconductor support structures compared to layer transfer techniques.

## Description

### Background

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize the performance of each device and each interconnect becomes increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a block illustration of an integrated circuit (IC) structure with improved bonding between a semiconductor layer and a non-semiconductor support structure, according to some embodiments of the present disclosure.
FIG. 2 provides a flow diagram of an example method of fabricating an IC structure with improved bonding between a semiconductor layer and a non-semiconductor support structure, according to some embodiments of the present disclosure.
FIGS. 3A-3F illustrate example results of various processes of the method shown in FIG. 2, according to some embodiments of the present disclosure.
FIG. 4 is a cross-sectional side view of an IC package that may include an IC device with an IC structure with improved bonding between a semiconductor layer and a non-semiconductor support structure in accordance with any of the embodiments disclosed herein.
FIG. 5 is a cross-sectional side view of an IC device assembly that may include an IC device with an IC structure with improved bonding between a semiconductor layer and a non-semiconductor support structure in accordance with any of the embodiments disclosed herein.
FIG. 6 is a block diagram of an example computing device that may include an IC device with an IC structure with improved bonding between a semiconductor layer and a non-semiconductor support structure in accordance with any of the embodiments disclosed herein.

### Detailed Description

### Overview

The systems, methods and devices of this disclosure each have several innovative aspects, no single one of which is solely responsible for all of the desirable attributes disclosed herein. Details of one or more implementations of the subject matter described in this specification are set forth in the description below and the accompanying drawings.

For purposes of illustrating IC devices and assemblies with IC structures with improved bonding between a semiconductor layer and a non-semiconductor support structure as described herein, it might be useful to first understand phenomena that may come into play in certain IC arrangements. The following foundational information may be viewed as a basis from which the present disclosure may be properly explained. Such information is offered for purposes of explanation only and, accordingly, should not be construed in any way to limit the broad scope of the present disclosure and its potential applications.

Non-semiconductor support structures (e.g., glass, mica, sapphire, etc.) provide unique advantages for forming IC circuits of semiconductor devices (e.g., transistors) on, compared to conventional semiconductor substrates. For example, non-semiconductor support structures may have lower dielectric constants than those of conventional semiconductor substrates (e.g., lower than about 11), which may advantageously decrease various parasitic effects associated with the IC device, since such parasitic effects are typically proportional to the dielectric constant of the surrounding medium. Many types of semiconductor materials that could serve as a foundation for forming IC circuits of semiconductor devices cannot be directly grown on non-semiconductor support structures. Examples of such semiconductor materials include III-N materials (e.g., GaN, AIGaN, InGaN, and so on), substantially monocrystalline silicon (Si), germanium (Ge), or SiGe, and so on. Rather, their fabrication could involve high-temperature growth processes (e.g., epitaxial growth processes) to grow target semiconductor materials on semiconductor support structures (e.g., semiconductor substrates), followed by a layer transfer process where a layer of a semiconductor material grown on a semiconductor support structure is transferred onto a non-semiconductor support structure. In such fabrication approaches, attachment of a semiconductor layer to a non-semiconductor support structure may rely simply on molecular interactions between the semiconductor layer and the non-semiconductor support structure.

While fabrication approaches as described above could be suitable in many settings, there are also potential drawbacks. For example, inventors of the present disclosure realized that delamination of the semiconductor layers from the non-semiconductor support structures may occur with time, compromising performance of IC devices and assemblies.

Embodiments of the present disclosure relate to methods of fabricating IC devices with IC structures with improved bonding between a semiconductor layer and a non-semiconductor support structure, as well as resulting IC devices, assemblies, and systems. An example method includes providing (e.g., epitaxially growing) a semiconductor material over a semiconductor support structure and, subsequently, depositing a first bonding material on the semiconductor material. The method further includes depositing a second bonding material on a support structure of a non-semiconductor material (i.e., on a non-semiconductor support structure) having a dielectric constant that is smaller than a dielectric constant of silicon (e.g., on a glass or a mica wafer), followed by bonding the face of the semiconductor material with the first bonding material to the face of the non-semiconductor support structure with the second bonding material. Using first and second bonding materials that include silicon, nitrogen, and oxygen (e.g., silicon oxynitride), e.g., bonding materials that include carbon, silicon, nitrogen, and oxygen (e.g., carbon-doped silicon oxynitride) may significantly improve bonding between semiconductor layers and non-semiconductor support structures, compared to layer transfer techniques described above. IC structures with improved bonding between a semiconductor layer and a non-semiconductor support structure may be used in many applications, e.g., as chiplets for power delivery, where semiconductor materials such as GaN or other III-N materials may be used to form IC devices (e.g., transistors) of voltage regulator circuits. In some embodiments, non-semiconductor support structures may be glass support structures, and may include any type of glass materials, since glass has dielectric constants in a range between about 5 and 10.5. However, in other embodiments, non-semiconductor support structures may include materials other than glass, e.g., mica or sapphire, as long as those materials have sufficiently low dielectric constants.

In the following detailed description, various aspects of the illustrative implementations will be described using terms commonly employed by those skilled in the art to convey the substance of their work to others skilled in the art. For example, a term "interconnect" may be used to describe any element formed of an electrically conductive material for providing electrical connectivity to one or more components associated with an IC or/and between various such components. In general, the "interconnect" may refer to both conductive lines/wires (also sometimes referred to as "lines" or "metal lines" or "trenches") and conductive vias (also sometimes referred to as "vias" or "metal vias"). In general, a term "conductive line" may be used to describe an electrically conductive element isolated by a dielectric material typically comprising an interlayer low-k dielectric that is provided within the plane of an IC chip. Such conductive lines are typically arranged in several levels, or several layers, of metallization stacks. On the other hand, the term "conductive via" may be used to describe an electrically conductive element that interconnects two or more conductive lines of different levels of a metallization stack. To that end, a via may be provided substantially perpendicularly to the plane of an IC chip or a support structure over which an IC structure is provided and may interconnect two conductive lines in adjacent levels or two conductive lines in not adjacent levels. A term "metallization stack" may be used to refer to a stack of one or more interconnects for providing connectivity to different circuit components of an IC chip.

In another example, the terms "package" and "IC package" are synonymous, as are the terms "die" and "IC die," the term "insulating" means "electrically insulating," the term "conducting" means "electrically conducting," unless otherwise specified. Although certain elements may be referred to in the singular herein, such elements may include multiple sub-elements. For example, "an electrically conductive material" may include one or more electrically conductive materials. If used, the terms "oxide," "carbide," "nitride," etc. refer to compounds containing, respectively, oxygen, carbon, nitrogen, etc., the term "high-k dielectric" refers to a material having a higher dielectric constant than silicon oxide, while the term "low-k dielectric" refers to a material having a lower dielectric constant than silicon oxide. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices. The term "circuit" may be used to describe one or more passive and/or active components that are arranged to cooperate with one another to provide a desired function. The terms "substantially," "close," "approximately," "near," and "about," generally refer to being within +/- 20% of a target value, e.g., within +/- 5% of a target value or within +/- 1% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/- 5-20% of a target value based on the context of a particular value as described herein or as known in the art.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. As used herein, the notation "A/B/C" means (A), (B), and/or (C).

The description may use the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

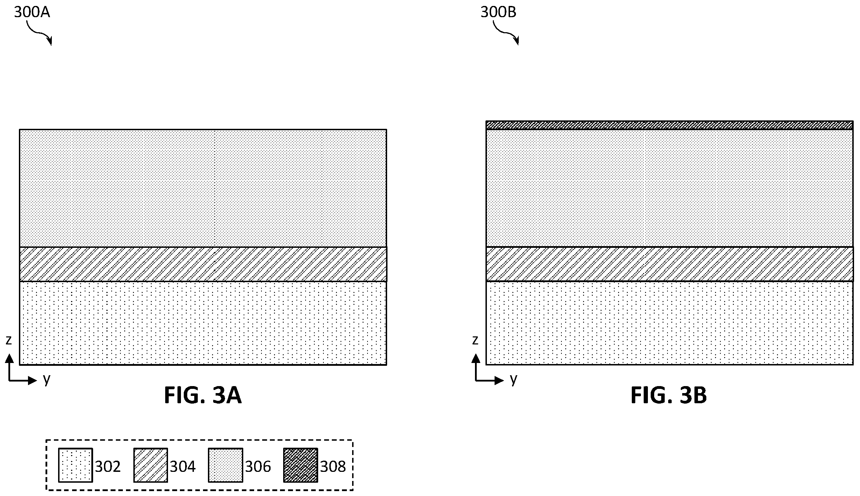

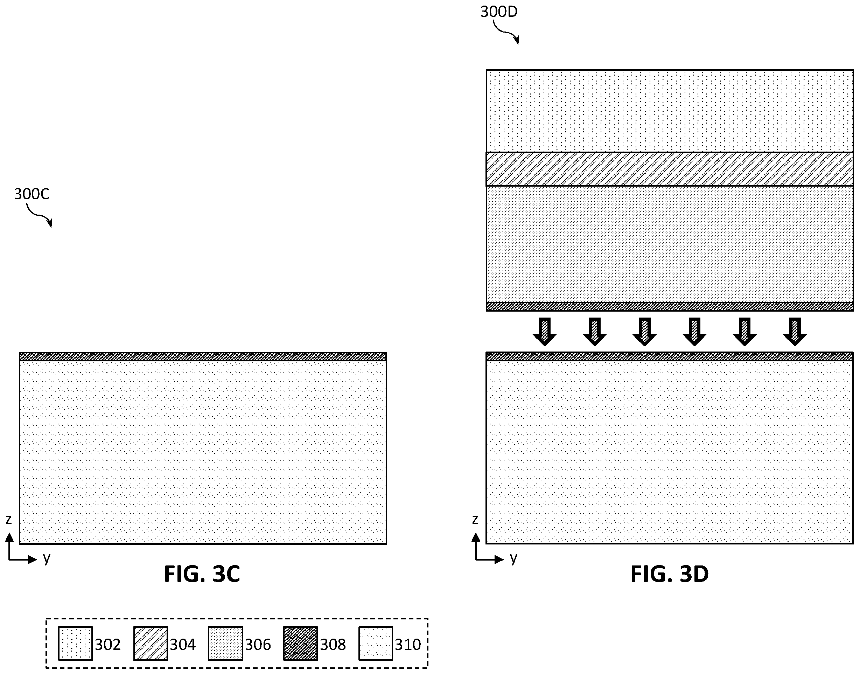

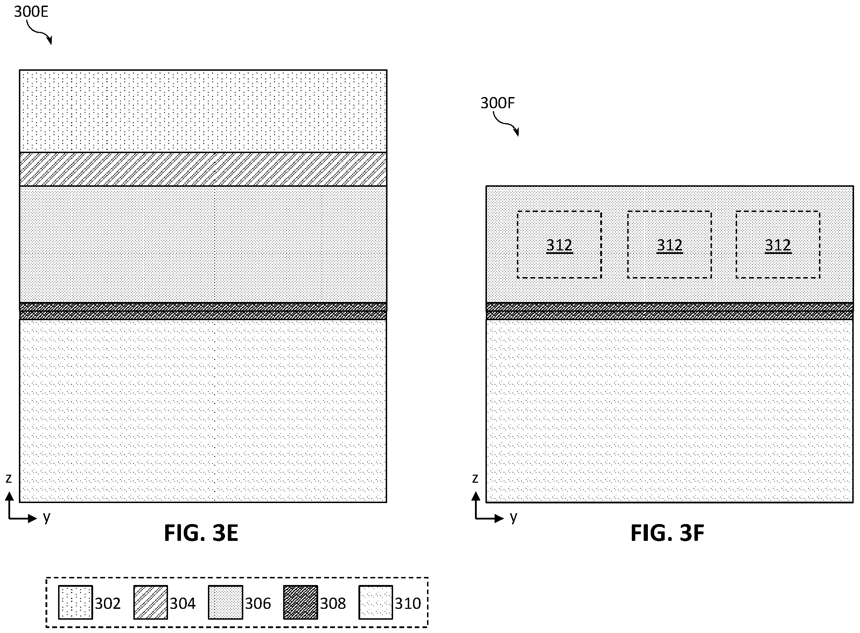

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, if a collection of drawings designated with different letters are present, e.g., FIGS. 3A-3F, such a collection may be referred to herein without the letters, e.g., as "FIG. 3."

In the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication.

Various devices and assemblies illustrated in the present drawings do not represent an exhaustive set of IC devices with IC structures with improved bonding between a semiconductor layer and a non-semiconductor support structure as described herein, but merely provide examples of such devices. In particular, the number and positions of various elements shown in the present drawings is purely illustrative and, in various other embodiments, other numbers of these elements, provided in other locations relative to one another may be used in accordance with the general architecture considerations described herein. Further, the present drawings are intended to show relative arrangements of the elements therein, and the devices and assemblies of these figures may include other elements that are not specifically illustrated (e.g., various interfacial layers). Similarly, although particular arrangements of materials are discussed with reference to the present drawings, intermediate materials may be included in the IC devices and assemblies of these figures. Still further, although some elements of the various cross-sectional views are illustrated in the present drawings as being planar rectangles or formed of rectangular solids, this is simply for ease of illustration, and embodiments of these assemblies may be curved, rounded, or otherwise irregularly shaped as dictated by, and sometimes inevitable due to, the manufacturing processes used to fabricate semiconductor device assemblies. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of the IC structures with improved bonding between a semiconductor layer and a non-semiconductor support structure as described herein.

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

Various IC assemblies with IC structures with improved bonding between a semiconductor layer and a non-semiconductor support structure as described herein may be implemented in, or associated with, one or more components associated with an IC or/and may be implemented between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

### Example IC devices and methods

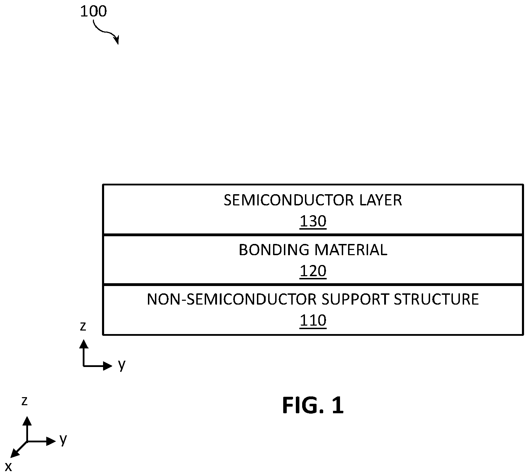

FIG. 1 provides a schematic block illustration of an example IC structure 100 with improved bonding between a semiconductor layer and a non-semiconductor support structure, according to some embodiments of the present disclosure. As shown in FIG. 1, in general, the IC structure 100 may include a non-semiconductor support structure 110, a bonding material 120, and a semiconductor layer 130 that includes a semiconductor material.

In some embodiments, the non-semiconductor support structure 110 may include a glass material, e.g., a glass substrate, a glass die, a glass wafer or a glass chip. Examples of glass materials include silicon oxide materials, possibly doped with elements and compounds such as boron, carbon, aluminum, hafnium oxide, e.g., in doping concentrations of between about 0.01% and 10%. In other embodiments, the non-semiconductor support structure 110 may include other solid materials having a dielectric constant lower than that of Si, e.g., lower than about 10.5. In some embodiments, the non-semiconductor support structure 110 may include mica, sapphire, or other non-semiconductor materials. A thickness of the non-semiconductor support structure 110 may be of any value for the non-semiconductor support structure 110 to provide mechanical stability for the IC structure 100 and, possibly, to support inclusion of various devices for further reducing the parasitic effects in the IC structure 100. In some embodiments, the non-semiconductor support structure 110 may have a thickness between about 0.2 micrometer (micron) and 1000 micron, e.g., between about 0.5 and 5 micron, or between about 1 and 3 micron. Although a few examples of materials from which the non-semiconductor support structure 110 may be formed are described here, any material with sufficiently low dielectric constant that may serve as a foundation to which the semiconductor layer 130 may be bonded using the bonding material 120, as described herein, falls within the spirit and scope of the present disclosure.

The semiconductor layer 130 may include a semiconductor material, and, in particular, a plurality of semiconductor devices fabricated based on the semiconductor material. While the semiconductor layer 130 is described herein as including a semiconductor material, the semiconductor material may include a plurality of different semiconductor materials. For example, in some embodiments, the semiconductor layer 130 may include different portions of different semiconductor materials, e.g., to enable formation of transistors with different threshold voltages. For example, the semiconductor layer 130 may include an area of a first semiconductor material and another area of a second semiconductor material, where the first semiconductor material is a relatively high-bandgap semiconductor material such as GaN, while the second semiconductor material is a lower bandgap semiconductor material such as Si, Ge, or SiGe. In another example, in some embodiments, at least portions of the semiconductor layer 130 may include layers of different semiconductor materials. For example, the semiconductor layer 130 may include a layer of a III-N semiconductor channel material and a layer of polarization material that forms a heterojunction with the III-N semiconductor channel material, for forming III-N transistors as known in the art.

In various embodiments, the semiconductor layer 130 may include semiconductor material systems including, for example, N-type or P-type materials systems. In some embodiments, the semiconductor layer 130 may include a monocrystalline semiconductor. In some embodiments, the semiconductor layer 130 may have a thickness between about 5 and 10000 nanometers, including all values and ranges therein, e.g., between about 10 and 500 nanometers, between about 10 and 200 nanometers, or about between 10 and 100 nanometers.

In some embodiments, the semiconductor layer 130 may be an upper layer of a semiconductor support structure (e.g., the semiconductor layer 130 may include silicon, e.g., an upper layer of silicon of a silicon substrate). Thus, in some implementations, the semiconductor layer 130 may be viewed as a part of the semiconductor support structure over which it is disposed, or as a part of the crystalline semiconductor upper part of such support structure. In some embodiments, an intermediate layer may be included as an insulating layer, such as an oxide isolation layer, over the semiconductor support structure and the semiconductor layer 130 may be provided over the oxide isolation layer, in a silicon-on-insulator (SOI) manner.

In some embodiments, the semiconductor layer 130 may be/include an intrinsic IV or III-V semiconductor material or alloy, not intentionally doped with any electrically active impurity. In alternate embodiments, nominal impurity dopant levels may be present within the semiconductor layer 130, for example to set a threshold voltage Vt, or to provide HALO pocket implants, etc. In such impurity-doped embodiments however, impurity dopant level within the semiconductor layer 130 may be relatively low, for example below about 10¹⁵ dopants per cubic centimeter (cm⁻³), and advantageously below 10¹³ cm⁻³.

In some embodiments, the semiconductor layer 130 may include a compound semiconductor with a first sub-lattice of at least one element from group III of the periodic table (e.g., Al, Ga, In), and a second sub-lattice of at least one element of group V of the periodic table (e.g., P, As, Sb). In some embodiments, the semiconductor layer 130 may include a binary, ternary, or quaternary III-V compound semiconductor that is an alloy of two, three, or even four elements from groups III and V of the periodic table, including boron, aluminum, indium, gallium, nitrogen, arsenic, phosphorus, antimony, and bismuth.

In some embodiments, the improved bonding method as described herein may be used to provide layers of III-N semiconductor materials onto non-semiconductor support structures. In such embodiments, the semiconductor layer 130 may include a III-N semiconductor material. In some embodiments, the III-N semiconductor material of the semiconductor layer 130 may be formed of a compound semiconductor with a first sub-lattice of at least one element from group III of the periodic table (e.g., Al, Ga, In), and a second sub-lattice of nitrogen (N). In some embodiments, the III-N semiconductor material of the semiconductor layer 130 may be a binary, ternary, or quaternary III-N compound semiconductor that is an alloy of two, three, or even four elements from group III of the periodic table (e.g., boron, aluminum, indium, gallium) and nitrogen.

In general, the III-N semiconductor material of the semiconductor layer 130 may be composed of various III-N semiconductor material systems including, for example, N-type or P-type III-N materials systems, depending on whether the III-N semiconductor material is an N-type or a P-type transistor. For some N-type transistor embodiments, the semiconductor layer 130 may advantageously include an III-N material having a high electron mobility, such as, but not limited to, GaN. In some embodiments, the III-N semiconductor material may be a ternary III-N alloy, such as InGaN, or a quaternary III-N alloy, such as AlInGaN, in any suitable stoichiometry. For some other exemplary N-type transistor embodiments, the semiconductor layer 130 may advantageously include an III-V material having a high electron mobility, such as, but not limited to InGaAs, InP, InSb, and InAs. For some such embodiments, the semiconductor layer 130 may include a ternary III-V alloy, such as InGaAs or GaAsSb. For some InₓGa₁₋ₓ,As fin embodiments, In content in the semiconductor layer 130 may be between 0.6 and 0.9, and advantageously at least 0.7 (e.g., In_{0.7}Ga_{0.3}As).

For exemplary P-type transistor embodiments, the semiconductor layer 130 may advantageously include a group IV material having a high hole mobility, such as, but not limited to, Ge or a Ge-rich SiGe alloy. For some exemplary embodiments, the semiconductor layer 130 may have a Ge content between 0.6 and 0.9, and advantageously is at least 0.7.

In some embodiments, the semiconductor layer 130 may include a thin-film semiconductor material, in which embodiments the transistors formed in the semiconductor layer 130 could be thin-film transistors (TFTs). A TFT is a special kind of a field-effect transistor (FET), made by depositing a thin film of an active semiconductor material, as well as a dielectric layer and metallic contacts, over a support structure that may be a non-conducting (and non-semiconducting) support structure. During operation of a TFT, at least a portion of the active semiconductor material forms a channel of the TFT, and, therefore, the thin film of such active semiconductor material is referred to herein as a "TFT channel material." This is different from conventional, non-TFT, transistors where the active semiconductor channel material is typically a part of a semiconductor substrate, e.g., a part of a silicon wafer. In various such embodiments, the semiconductor layer 130 may include a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the semiconductor layer 130 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphide, and black phosphorus, each of which may possibly be doped with one or more of gallium, indium, aluminum, fluorine, boron, phosphorus, arsenic, nitrogen, tantalum, tungsten, and magnesium, etc.

In some embodiments, the semiconductor layer 130 may include IGZO. IGZO-based devices have several desirable electrical and manufacturing properties. IGZO has high electron mobility compared to other semiconductors, e.g., in the range of 20-50 times than amorphous silicon. Furthermore, amorphous IGZO (a-IGZO) transistors are typically characterized by high band gaps, low-temperature process compatibility, and low fabrication cost relative to other semiconductors. IGZO can be deposited as a uniform amorphous phase while retaining higher carrier mobility than oxide semiconductors such as zinc oxide. Different formulations of IGZO include different ratios of indium oxide, gallium oxide, and zinc oxide. One particular form of IGZO has the chemical formula InGaO₃(ZnO)₅. Another example form of IGZO has an indium:gallium:zinc ratio of 1:2:1. In various other examples, IGZO may have a gallium to indium ratio of 1:1, a gallium to indium ratio greater than 1 (e.g., 2:1, 3:1, 4:1, 5:1, 6:1, 7:1, 8:1, 9:1, or 10:1), and/or a gallium to indium ratio less than 1 (e.g., 1:2, 1:3, 1:4, 1:5, 1:6, 1:7, 1:8, 1:9, or 1:10). IGZO can also contain tertiary dopants such as aluminum or nitrogen.

The plurality of semiconductor devices that may be formed in the semiconductor layer 130 may include transistors, diodes, and other devices that have active portions (e.g., channel regions of transistors) formed of the semiconductor material of the semiconductor layer 130. For example, the semiconductor layer 130 may include transistors, where portions of the semiconductor material of the semiconductor layer 130 form channel regions of the transistors. In various embodiments, such transistors may be planar transistors or non-planar transistors (e.g., FinFETs, nanoribbon transistors, nanowire transistors, etc.). In some embodiments, the transistors formed in the semiconductor layer 130 may form IC circuits of different functionality, such as voltage regulator circuits, power delivery circuits, compute logic circuits, memory circuits, etc. In some embodiments, the semiconductor layer 130 may further include a plurality of interconnects for routing signals and/or power to, from, and between various semiconductor devices implemented in the semiconductor layer 130.

The bonding material 120 between the non-semiconductor support structure 110 and the semiconductor layer 130 may be a material that includes silicon, nitrogen, and oxygen (e.g., the bonding material 120 may be silicon oxynitride), where the atomic percentage of any of these materials may be at least 1%, e.g., between about 1% and 50%, indicating that these elements are added deliberately, as opposed to being accidental impurities which are typically in concentration below about 0.1%. In some embodiments, the bonding material 120 may be carbon-doped, e.g., a carbon-doped silicon oxynitride (e.g., SiOCN), where the atomic percentage of carbon may be between about 0.001% and 10%. In some embodiments, a thickness of the bonding material 120 may be between about 1 and 10 nanometers, e.g., between about 2 and 8 nanometers, or between about 4 and 6 nanometers, e.g., around 5 nanometers.

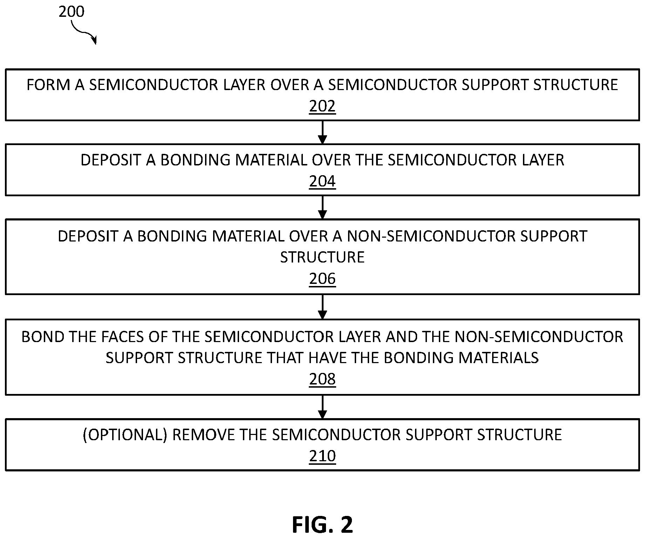

FIG. 2 provides a flow diagram of an example method 200 of fabricating an IC structure with improved bonding between a semiconductor layer and a non-semiconductor support structure, according to some embodiments of the present disclosure. The method 200 may be used to fabricate the IC structure 100 as shown in FIG. 1. FIGS. 3A-3F illustrate IC structures 300 as example results of various processes of the method 200 shown in FIG. 2, according to some embodiments of the present disclosure. In particular, each of FIGS. 3A-3F illustrates a cross-section of the IC structure 300 taken along the y-z plane of the reference coordinate system x-y-z shown in FIG. 1. A number of elements labeled in FIGS. 3A-3F with reference numerals are illustrated in these figures with different patterns, with a legend showing the correspondence between the reference numerals and patterns being provided at the bottom of each drawing page containing FIGS. 3A-3F.

The example fabrication method shown in FIGS. 2 and 3 may include other operations not specifically shown in FIGS. 2 and 3, such as various cleaning or planarization operations as known in the art. For example, in some embodiments, any of the layers of the IC structure may be cleaned prior to, after, or during any of the processes of the fabrication method described herein, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the top surfaces of the IC structures described herein may be planarized prior to, after, or during any of the processes of the fabrication method described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

As shown in FIG. 2, the method 200 may begin with a process 202 that includes forming a semiconductor layer over a semiconductor support structure. An IC structure 300A, shown in FIG. 3A, illustrates an example result of performing the process 202. As shown in FIG. 3A, the IC structure 300A may include a semiconductor support structure 302, an intermediate layer 304, and a semiconductor layer 306. In some embodiments, the intermediate layer 304 may be absent and the semiconductor layer 306 may be provided directly over the semiconductor support structure 302. The semiconductor layer 306 may include any of the materials described with reference to the semiconductor layer 130, as, in a later stage of the method 200, at least a portion of the semiconductor layer 306 will form the semiconductor layer 130 of an IC structure with improved bonding as described herein. Forming the semiconductor layer 306 in the process 202 may include epitaxially growing the semiconductor layer 306 over the intermediate layer 304 or over the semiconductor support structure 302.

In some embodiments, the intermediate layer 304 may include an insulator, and the semiconductor material 306 may include silicon (e.g., epitaxially grown silicon, e.g., crystalline silicon) and, together, the semiconductor support structure 302, the intermediate layer 304, and the semiconductor material 306 may form a SOI substructure. In case the semiconductor layer 306 includes a III-N semiconductor material, the intermediate layer 304 may include a buffer material. In some embodiments, the buffer material may be a layer of a semiconductor material that has a band gap larger than that of the III-N semiconductor material of the semiconductor layer 306. Furthermore, a properly selected semiconductor for the buffer material may enable better epitaxy of the III-N semiconductor material thereon, e.g., it may improve epitaxial growth of the III-N semiconductor material in terms of a bridge lattice constant or amount of defects. For example, a semiconductor that includes aluminum, gallium, and nitrogen (e.g., AlGaN) or a semiconductor that includes aluminum and nitrogen (e.g., AIN) may be used as the buffer material when the semiconductor layer 306 is a semiconductor that includes gallium and nitrogen (e.g., GaN). Other examples of materials for the buffer material of the intermediate layer 304 may include materials typically used as ILD, described above, such as oxide isolation layers, e.g., silicon oxide, silicon nitride, aluminum oxide, and/or silicon oxynitride. In various embodiments, the intermediate layer 304 may have a thickness between about 100 and 5000 nanometers, including all values and ranges therein, e.g., between about 200 and 1000 nanometers, or between about 250 and 500 nanometers.

The semiconductor support structure 302 may be a semiconductor substrate composed of semiconductor material systems including, for example, N-type or P-type materials systems. In one implementation, the semiconductor support structure 302 may be a crystalline substrate formed using a bulk silicon. In other implementations, the semiconductor support structure 302 may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the semiconductor support structure 302 may be non-crystalline. In some embodiments, the semiconductor support structure 302 may be a printed circuit board (PCB) substrate. Although a few examples of materials from which the semiconductor support structure 302 may be formed are described here, any material that may serve as a foundation upon which the semiconductor layer 130 as described herein may be built falls within the spirit and scope of the present disclosure.

The method 200 may then proceed with a process 204 that includes depositing a bonding material over the semiconductor layer formed in the process 202. An IC structure 300B, shown in FIG. 3B, illustrates an example result of performing the process 204. As shown in FIG. 3B, the IC structure 300B may include a bonding material 308, deposited over the semiconductor layer 306. The bonding material 308 may include any of the materials described with reference to the bonding material 120. In some embodiments, a thickness of the bonding material 308 may be about half of the thickness described above with respect to the bonding material 120. In various embodiments, the bonding material 308 may be deposited in the process 204 using techniques such as, but not limited to, atomic layer deposition (ALD), chemical vapor deposition (CVD), plasma enhanced CVD (PECVD), or physical vapor deposition (PVD) (e.g., evaporative deposition, magnetron sputtering, or e-beam deposition.

The method 200 may also include a process 206 that includes depositing a bonding material over a non-semiconductor support structure. An IC structure 300C, shown in FIG. 3C, illustrates an example result of performing the process 206. As shown in FIG. 3C, the IC structure 300C may include the bonding material 308 as described above, deposited over a non-semiconductor support structure 310. The non-semiconductor support structure 310 may include any of the non-semiconductor support structures described with reference to the non-semiconductor support structure 110. In some embodiments, the bonding material 308 deposited over the non-semiconductor support structure 310 in the process 206 may have substantially the same material composition and/or the same thickness as the bonding material 308 deposited over the semiconductor layer 306 in the process 204. In other embodiments, material compositions and/or thicknesses of the bonding materials 30 deposited in the processes 204 and 206 may be different. Although the process 206 is shown in FIG. 2 to be after the process 204, in various embodiments, the process 206 may be performed before, after, or simultaneously with any portions of the processes 202 and 204.

The method 200 may then proceed with a process 208 that includes bonding the faces of the semiconductor layer and the non-semiconductor support structure that have bonding materials thereon together. An IC structure 300D, shown in FIG. 3D, illustrates an example result of performing the process 208. As shown in FIG. 3D, the IC structure 300D may be formed by flipping the IC structure 300B over and bonding it to the top of the IC structure 300C, so that the bonding material 308 deposited over the semiconductor layer 306 in the process 204 is brought in contact with and bonded to the bonding material 308 deposited over the non-semiconductor support structure 310 in the process 206. During the bonding of the process 208, the IC structures 300B and 300C may be brought together in this manner, possibly while applying a suitable pressure and heating up the assembly to a suitable temperature (e.g., to moderately high temperatures, e.g., between about 50 and 200 degrees Celsius) for a duration of time, thus forming an IC structure 300E as shown in FIG. 3E, with the bonded materials 308 deposited in the processes 204 and 206 being adjoined together, providing an adhesive interface that ensures attachment of the semiconductor layer 306 and the non-semiconductor support structure 310 to one another. The use of the bonding material 308 as described herein makes the IC structure 300E have improved bonding between the semiconductor layer 306 and the non-semiconductor support structure 302, compared to what may be achievable using layer transfer techniques.

The method 200 may also, optionally, include a process 210 in which some or all of the semiconductor support structure used in the process 202 may be removed. An IC structure 300F, shown in FIG. 3F, illustrates an example result of performing the process 210. As shown in FIG. 3F, the semiconductor support structure 302 and the intermediate layer 304 may be removed in the process 210. In some embodiments, such removal may be performed using any suitable thinning/polishing processes as known in the art, to reveal the semiconductor layer 306. At this point, the non-semiconductor support structure 310 may provide the mechanical stability to the microelectronic assembly of the IC structure 300F.

FIG. 3F further illustrates that, in some embodiments, ICs 312 may be included in the semiconductor layer 306. The ICs 312 may include any suitable IC devices formed based on the semiconductor layer 306. For example, one or more of the ICs 312 may include voltage regulator circuits. Although not specifically shown in FIG. 3F, the semiconductor layer 306 may further include a plurality of interconnects to/from/between the ICs 312.

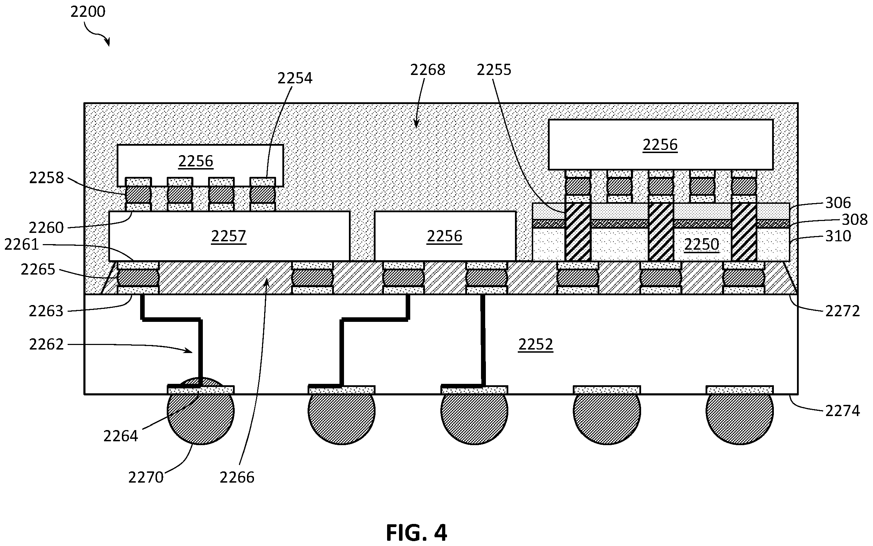

IC structures 300E and 300F are some examples of how the IC structure 100 may be implemented. In general, the IC structure 100 with improved bonding between a semiconductor layer and a non-semiconductor support structure as disclosed herein may be included in any suitable electronic device. FIGS. 4-6 illustrate various examples of devices and components that may include one or more IC structures 100.

FIG. 4 is a cross-sectional side view of an IC package 2200 that may include an IC structure with improved bonding between a semiconductor layer and a non-semiconductor support structure in accordance with any of the embodiments disclosed herein, e.g., that may include any embodiments of the IC structure 100, described herein. In some embodiments, the IC package 2200 may be a system-in-package (SiP).

As shown in FIG. 4, the IC package 2200 may include a package substrate 2252. The package substrate 2252 may be formed of a dielectric material (e.g., a ceramic, a buildup film, an epoxy film having filler particles therein, etc.), and may have conductive pathways extending through the dielectric material between the face 2272 and the face 2274, or between different locations on the face 2272, and/or between different locations on the face 2274. For example, the package substrate 2252 may include conductive contacts 2263 that are coupled to conductive pathways 2262 through the package substrate 2252, allowing circuitry within the dies 2256 and/or the interposer 2257 to electrically couple to various ones of the conductive contacts 2264 (or to other devices included in the package substrate 2252, not shown).

The IC package 2200 may include an interposer 2257 coupled to the package substrate 2252 via conductive contacts 2261 of the interposer 2257, first-level interconnects 2265 (e.g., die-to-package substrate (DTPS) interconnects), and the conductive contacts 2263 of the package substrate 2252. The first-level interconnects 2265 illustrated in FIG. 4 are solder bumps, but any suitable first-level interconnects 2265 may be used. In some embodiments, no interposer 2257 may be included in the IC package 2200; instead, any of the dies 2256 may be coupled directly to the conductive contacts 2263 at the face 2272 by first-level interconnects 2265, as is shown in FIG. 4 with the die 2256 shown in the middle.

The IC package 2200 may include one or more dies 2256 coupled to the interposer 2257 via conductive contacts 2254 of the dies 2256, first-level interconnects 2258 (e.g., die-to-die (DTD) interconnects), and conductive contacts 2260 of the interposer 2257. The conductive contacts 2260 may be coupled to conductive pathways (not shown) through the interposer 2257, allowing circuitry within the dies 2256 to electrically couple to various ones of the conductive contacts 2261 (or to other devices included in the interposer 2257, not shown). The first-level interconnects 2258 illustrated in FIG. 4 are solder bumps, but any suitable first-level interconnects 2258 may be used. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

The IC package 2200 may also include an IC structure 2250, coupled to the package substrate 2252 by the first-level interconnects 2265 similar to how the interposer 2257 or any of the dies 2256 may be coupled to the package substrate 2252. The IC structure 2250 may be the IC structure 100 according to any embodiments described herein. To that end, the semiconductor layer 306, the bonding material 308, and the non-semiconductor support structure 310 are individually labeled in FIG. 4. In some embodiments, one or more of the dies 2256 may be coupled to the IC structure 2250 using first-level interconnects 2258. For example, the IC structure 2250 may include conductive contacts 2261 on the face of the IC structure 2250 that is closest to the package substrate 2252, and further include conductive contacts 2260 on the face of the IC structure 2250 that is farthest away from the package substrate 2252. The conductive contacts 2261 of the IC structure 2250 and the first-level interconnects 2265 coupled to these conductive contacts may couple the IC structure 2250 to the conductive contacts 2263 at the face 2272 of the package substrate 2252. The conductive contacts 2260 of the IC structure 2250 and the first-level interconnects 2258 coupled to these conductive contacts may couple the IC structure 2250 to the conductive contacts 2254 at the opposing face of the die 2256. In some embodiments, through-vias 2255 may be coupled between some of the conductive contacts 2261 of the IC structure 2250 and some of the conductive contacts 2260 of the IC structure 2250. The through-vias 2255 may be used to provide power from the package substrate 2252 and/or from the second-level interconnects 2270 to the die 2256 coupled to the IC structure 2250. The through-vias 2255 may be formed in the IC structure 2250 after the bonding using the bonding material 308 has been performed. In some embodiments, a pitch of the through-vias 2255 may be between about 5 and 70 micrometers, e.g., between about 25 and 50 micrometers. Formation of the through-vias 2255 may create local stresses, so it may be advantageous to arrange the through-vias 2255 at a certain minimum distance from one another to ensure structural stability of the IC structure 100 (e.g., of the IC structure 2250). In some embodiments, cross-sectional dimensions (e.g., diameters or widths) of the through-vias 2255 are between about 7 and 11 micrometers, e.g., about 9 micrometers. In some embodiments, the cross-sectional dimensions of the through-vias 2255 may be between about 35% and 65%, e.g., between about 45% and 55%, of the pitch of the vias. Although not specifically shown in FIG. 4, the semiconductor layer 306 may include one or more ICs 312 as described above, e.g., in order to perform voltage regulation before providing power and/or signals from the package substrate 2252 and/or from the second-level interconnects 2270 to the die 2256 coupled to the IC structure 2250. In such implementations, the IC structure 2250 may be a chiplet for power delivery to the die 2256 that is coupled to the IC structure 2250. One or more of the through-vias 2255 may be coupled to any of the ICs 312 that may be included in the semiconductor layer 306 of the IC structure 2250. In some embodiments, the semiconductor layer 306 may be closer to the die 2256 than the non-semiconductor support structure 302 (i.e., the non-semiconductor support structure 302 may be closer to the package substrate 2252 than the semiconductor layer 306). In some embodiments, any of the dies 2256 may include one or more of the IC structures 100 with improved bonding between a semiconductor layer and a non-semiconductor support structure in accordance with any of the embodiments disclosed herein.

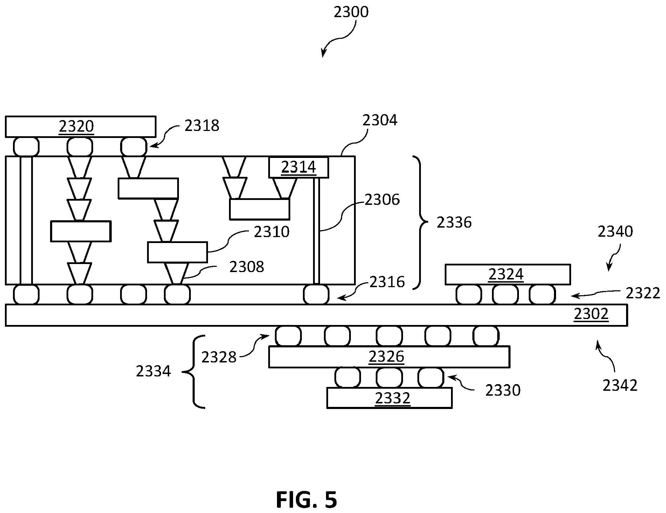

In some embodiments, an underfill material 2266 may be disposed between the package substrate 2252 and the interposer 2257 around the first-level interconnects 2265, and a mold compound 2268 may be disposed around the dies 2256, the interposer 2257, and the IC structure 2250, and in contact with the package substrate 2252. In some embodiments, the underfill material 2266 may be the same as the mold compound 2268. Example materials that may be used for the underfill material 2266 and the mold compound 2268 are epoxy mold materials, as suitable. Second-level interconnects 2270 may be coupled to the conductive contacts 2264. The second-level interconnects 2270 illustrated in FIG. 4 are solder balls (e.g., for a ball grid array arrangement), but any suitable second-level interconnects 2270 may be used (e.g., pins in a pin grid array arrangement or lands in a land grid array arrangement). The second-level interconnects 2270 may be used to couple the IC package 2200 to another component, such as a circuit board (e.g., a motherboard), an interposer, or another IC package, as known in the art and as discussed below with reference to FIG. 5.

In embodiments in which the IC package 2200 includes multiple dies 2256, the IC package 2200 may be referred to as a multi-chip package (MCP). The dies 2256 may include circuitry to perform any desired functionality. For example, one or more of the dies 2256 may be logic dies (e.g., silicon-based dies), and one or more of the dies 2256 may be memory dies (e.g., high bandwidth memory), including embedded logic and memory devices as described herein. In some embodiments, any of the dies 2256 may include one or more IC structures with improved bonding between a semiconductor layer and a non-semiconductor support structure, e.g., as discussed above; in some embodiments, at least some of the dies 2256 may not include any of the IC structures with improved bonding between a semiconductor layer and a non-semiconductor support structure.

The IC package 2200 illustrated in FIG. 4 may be a flip chip package, although other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fan-out (FO) package. Although three dies 2256 are illustrated in the IC package 2200 of FIG. 4, an IC package 2200 may include any desired number of the dies 2256. An IC package 2200 may include additional passive components, such as surface-mount resistors, capacitors, and inductors disposed on the first face 2272 or the second face 2274 of the package substrate 2252, or on either face of the interposer 2257, or on either face of the IC structure 2250. More generally, an IC package 2200 may include any other active or passive components known in the art.

FIG. 5 is a cross-sectional side view of an IC device assembly 2300 that may include components having one or more IC structures with improved bonding between a semiconductor layer and a non-semiconductor support structure in accordance with any of the embodiments disclosed herein, e.g., that may include any embodiments of the IC structure 100, described herein. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. In particular, any suitable ones of the components of the IC device assembly 2300 may include any of one or more IC structures with improved bonding between a semiconductor layer and a non-semiconductor support structure in accordance with any of the embodiments disclosed herein; e.g., any of the IC packages discussed below with reference to the IC device assembly 2300 may take the form of any of the embodiments of the IC package 2200 discussed above with reference to FIG. 4 (e.g., may include one or more IC structures with improved bonding between a semiconductor layer and a non-semiconductor support structure).

In some embodiments, the circuit board 2302 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 5 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (e.g., as shown in FIG. 5), male and female portions of a socket, an adhesive, an underfill material, and/or any other suitable electrical and/or mechanical coupling structure.

The package-on-interposer structure 2336 may include an IC package 2320 coupled to an interposer 2304 by coupling components 2318. The coupling components 2318 may take any suitable form for the application, such as the forms discussed above with reference to the coupling components 2316. The IC package 2320 include one or more IC structures with improved bonding between a semiconductor layer and a non-semiconductor support structure as described herein. Although a single IC package 2320 is shown in FIG. 5, multiple IC packages may be coupled to the interposer 2304; indeed, additional interposers may be coupled to the interposer 2304. The interposer 2304 may provide an intervening substrate used to bridge the circuit board 2302 and the IC package 2320. Generally, the interposer 2304 may spread a connection to a wider pitch or reroute a connection to a different connection. For example, the interposer 2304 may couple the IC package 2320 (e.g., a die) to a BGA of the coupling components 2316 for coupling to the circuit board 2302. In the embodiment illustrated in FIG. 5, the IC package 2320 and the circuit board 2302 are attached to opposing sides of the interposer 2304; in other embodiments, the IC package 2320 and the circuit board 2302 may be attached to a same side of the interposer 2304. In some embodiments, three or more components may be interconnected by way of the interposer 2304.

The interposer 2304 may be formed of an epoxy resin, a fiberglass-reinforced epoxy resin, a ceramic material, or a polymer material such as polyimide. In some implementations, the interposer 2304 may be formed of alternate rigid or flexible materials that may include the same materials described above for use in a semiconductor substrate, such as silicon, germanium, and other group III-V and group IV materials. The interposer 2304 may include metal interconnects 2308 and vias 2310, including but not limited to through-silicon vias (TSVs) 2306. The interposer 2304 may further include embedded devices 2314, including both passive and active devices. Such devices may include, but are not limited to, capacitors, decoupling capacitors, resistors, inductors, fuses, diodes, transformers, sensors, electrostatic discharge (ESD) protection devices, and memory devices. More complex devices such as radio frequency (RF) devices, power amplifiers, power management devices, antennas, arrays, sensors, and microelectromechanical systems (MEMS) devices may also be formed on the interposer 2304. The package-on-interposer structure 2336 may take the form of any of the package-on-interposer structures known in the art. Descriptions provided for the interposer 2304 are also applicable to the interposer 2257 of the IC package 2200, shown in FIG. 4.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 5 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

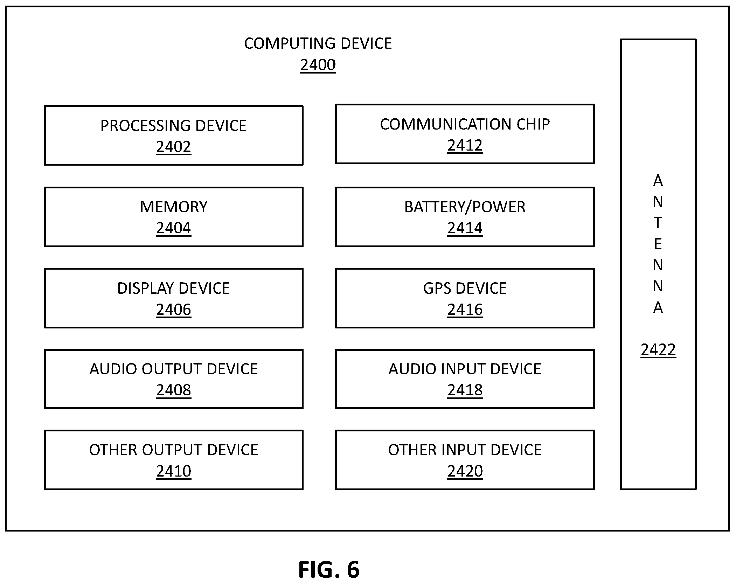

FIG. 6 is a block diagram of an example computing device 2400 that may include one or more components with one or more IC structures with improved bonding between a semiconductor layer and a non-semiconductor support structure in accordance with any of the embodiments disclosed herein, e.g., that may include any embodiments of the IC structure 100, described herein. Any of the components of the computing device 2400 may include an IC package 2200 as described with reference to FIG. 4. Any of the components of the computing device 2400 may include an IC device assembly 2300 as described with reference to FIG. 5.

A number of components are illustrated in FIG. 6 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single system-on-chip (SoC) die.

Additionally, in various embodiments, the computing device 2400 may not include one or more of the components illustrated in FIG. 6, but the computing device 2400 may include interface circuitry for coupling to the one or more components. For example, the computing device 2400 may not include a display device 2406, but may include display device interface circuitry (e.g., a connector and driver circuitry) to which a display device 2406 may be coupled. In another set of examples, the computing device 2400 may not include an audio input device 2418 or an audio output device 2408, but may include audio input or output device interface circuitry (e.g., connectors and supporting circuitry) to which an audio input device 2418 or audio output device 2408 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 2400 may include a memory 2404, which may itself include one or more memory devices such as volatile memory (e.g., DRAM), nonvolatile memory (e.g., read-only memory (ROM)), flash memory, solid state memory, and/or a hard drive. In some embodiments, the memory 2404 may include memory that shares a die with the processing device 2402.

In some embodiments, the computing device 2400 may include a communication chip 2412 (e.g., one or more communication chips). For example, the communication chip 2412 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2412 may implement any of a number of wireless standards or protocols, including but not limited to Institute for Electrical and Electronic Engineers (IEEE) standards including Wi-Fi (IEEE 602.11 family), IEEE 602.16 standards (e.g., IEEE 602.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 602.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 602.16 standards. The communication chip 2412 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2412 may operate in accordance with other wireless protocols in other embodiments. The computing device 2400 may include an antenna 2422 to facilitate wireless communications and/or to receive other wireless communications (such as AM or FM radio transmissions).

In some embodiments, the communication chip 2412 may manage wired communications, such as electrical, optical, or any other suitable communication protocols (e.g., the Ethernet). As noted above, the communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

The computing device 2400 may include battery/power circuitry 2414. The battery/power circuitry 2414 may include one or more energy storage devices (e.g., batteries or capacitors) and/or circuitry for coupling components of the computing device 2400 to an energy source separate from the computing device 2400 (e.g., AC line power).

The computing device 2400 may include a display device 2406 (or corresponding interface circuitry, as discussed above). The display device 2406 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2408 (or corresponding interface circuitry, as discussed above). The audio output device 2408 may include any device that generates an audible indicator, such as speakers, headsets, or earbuds, for example.

The computing device 2400 may include an audio input device 2418 (or corresponding interface circuitry, as discussed above). The audio input device 2418 may include any device that generates a signal representative of a sound, such as microphones, microphone arrays, or digital instruments (e.g., instruments having a musical instrument digital interface (MIDI) output).

The computing device 2400 may include a GPS device 2416 (or corresponding interface circuitry, as discussed above). The GPS device 2416 may be in communication with a satellite-based system and may receive a location of the computing device 2400, as known in the art.

The computing device 2400 may include an other output device 2410 (or corresponding interface circuitry, as discussed above). Examples of the other output device 2410 may include an audio codec, a video codec, a printer, a wired or wireless transmitter for providing information to other devices, or an additional storage device.

The computing device 2400 may include an other input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

### Select examples

The following paragraphs provide various examples of the embodiments disclosed herein.

Example 1 provides an IC device that includes an IC structure that includes a support structure of a non-semiconductor material having a dielectric constant that is smaller than a dielectric constant of silicon (e.g., a glass support structure); a semiconductor layer, wherein a portion of the semiconductor layer includes a semiconductor material; and a bonding material between the support structure and the semiconductor layer, wherein the bonding material includes silicon, nitrogen, and oxygen, e.g., the bonding material is silicon oxynitride.

Example 2 provides the IC device according to example 1, wherein the bonding material further includes carbon, e.g., the bonding material is carbon-doped silicon oxynitride. The atomic percentage of carbon may be between about 0.001% and 10%.

Example 3 provides the IC device according to any one of the preceding examples, where a thickness of the bonding material is between about 1 and 10 nanometers, e.g., between about 2 and 8 nanometers, or between about 4 and 6 nanometers, e.g., around 5 nanometers.

Example 4 provides the IC device according to any one of the preceding examples, where the semiconductor layer includes a plurality of transistors, where channel regions of the transistors include portions of the semiconductor material.

Example 5 provides the IC device according to example 4, where the plurality of transistors form voltage regulator circuitry.

Example 6 provides the IC device according to any one of the preceding examples, where each of the support structure and the semiconductor layer includes a first face and a second face, the second face being opposite the first face, the bonding material is between the second face of the support structure and the second face of the semiconductor layer, and the IC structure further includes a plurality of vias that extend between the first face of the support structure and the first face of the semiconductor layer. Such vias may be used to deliver power from a further IC component (e.g., a package substrate or a carrier substrate), coupled to the first face of the support structure, to another die coupled to the first face of the semiconductor layer.

Example 7 provides the IC device according to example 6, where a pitch of the vias is between about 5 and 70 micrometers, e.g., between about 25 and 50 micrometers.

Example 8 provides the IC device according to examples 6 or 7, where cross-sectional dimensions (e.g., diameters or widths) of the vias are between about 7 and 11 micrometers, e.g., about 9 micrometers. In some embodiments, the cross-sectional dimensions of these vias may be between about 35% and 65%, e.g., between about 45% and 55%, of the pitch of the vias.

Example 9 provides the IC device according to any one of examples 6-8, further including a die, coupled to the first face of the semiconductor layer by DTD interconnects, where at least one of the vias is coupled to at least one of the DTD interconnects.

Example 10 provides the IC device according to example 9, further including a package substrate, coupled to the first face of the support structure by DTPS interconnects, where at least one of the vias coupled to one of the DTD interconnects is also coupled to one of the DTPS interconnects.

Example 11 provides the IC device according to example 10, where a pitch of the DTPS interconnects is larger than a pitch of the DTD interconnects.

Example 12 provides the IC device according to any one of the preceding examples, where the semiconductor material includes a III-N semiconductor material.

Example 13 provides the IC device according to any one of the preceding examples, where the semiconductor material includes germanium.

Example 14 provides the IC device according to any one of the preceding examples, where the semiconductor material includes silicon and germanium (e.g., SiGe).

Example 15 provides the IC device according to any one of the preceding examples, where the semiconductor layer includes a plurality of portions with different semiconductor materials, where the semiconductor material is one of the different semiconductor materials in one of the portions.

Example 16 provides the IC device according to example 15, where a first portion of the plurality of portions includes a III-N semiconductor material, and a second portion of the plurality of portions includes silicon germanium or germanium.

Example 17 provides an IC package that includes an IC device; and a further IC component, coupled to the IC device, where the IC device may be an IC device according to any one of the preceding examples.

Example 18 provides the IC package according to example 17, where the further IC component includes one of a package substrate, an interposer, or a further IC die.

Example 19 provides the IC package according to examples 17 or 18, where the IC package includes, or is a part of, at least one of a memory device, a computing device, a wearable device, a handheld electronic device, and a wireless communications device.

Example 20 provides the IC package according to any one of examples 17-19, where the IC device includes, or is a part of, at least one of a memory device, a computing device, a wearable device, a handheld electronic device, and a wireless communications device.

Example 21 provides an electronic device that includes a carrier substrate; and one or more of the IC device according to any one of the preceding examples and the IC package according to any one of the preceding examples, coupled to the carrier substrate.

Example 22 provides the electronic device according to example 21, where the carrier substrate is a motherboard.

Example 23 provides the electronic device according to example 21, where the carrier substrate is a PCB.

Example 24 provides the electronic device according to any one of examples 21-23, where the electronic device is a wearable electronic device (e.g., a smart watch) or handheld electronic device (e.g., a mobile phone).

Example 25 provides the electronic device according to any one of examples 21-24, where the electronic device further includes one or more communication chips and an antenna.

Example 26 provides the electronic device according to any one of examples 21-25, where the electronic device is an RF transceiver.

Example 27 provides the electronic device according to any one of examples 21-25, where the electronic device is one of a switch, a power amplifier, a low-noise amplifier, a filter, a filter bank, a duplexer, an upconverter, or a downconverter of an RF communications device, e.g., of an RF transceiver.

Example 28 provides the electronic device according to any one of examples 21-25, where the electronic device is a computing device.

Example 29 provides the electronic device according to any one of examples 21-28, where the electronic device is included in a base station of a wireless communication system.

Example 30 provides the electronic device according to any one of examples 21-28, where the electronic device is included in a user equipment device (i.e., a mobile device) of a wireless communication system.

Example 31 provides a method of fabricating an IC device. The method includes providing a semiconductor material over a semiconductor support structure; depositing a first bonding material on the semiconductor material; depositing a second bonding material on a support structure of a non-semiconductor material having a dielectric constant that is smaller than a dielectric constant of silicon (e.g., a glass support structure); and bonding a face of the semiconductor material with the first bonding material to a face of the support structure of the non-semiconductor material with the second bonding material, where each of the first and second bonding materials includes silicon, nitrogen, and oxygen, e.g., the bonding materials include silicon oxynitride.

Example 32 provides the method according to example 31, further including: after the bonding, removing the semiconductor support structure.

Example 33 provides the method according to example 31, wherein removing the semiconductor support structure includes polishing or grinding away the semiconductor support structure until the semiconductor material is exposed.

Example 34 provides the method according to any one of examples 31-33, a thickness of the first bonding material or a thickness of the second bonding material is between about 0.5 and 5 nanometers, e.g., between about 1 and 4 nanometers, or between about 2 and 3 nanometers, e.g., around 2.5 nanometers.

Example 35 provides the method according to any one of examples 31-34, where the non-semiconductor support structure includes glass.

Example 36 provides the method according to any one of examples 31-35, where the non-semiconductor support structure includes mica.

Example 37 provides the method according to any one of examples 31-36, further including processes for forming the IC device according to any one of the preceding examples (e.g., for forming the IC device according to any one of examples 1-16).

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device, comprising:
an IC structure that includes:
a support structure of a non-semiconductor material;
a semiconductor layer, wherein a portion of the semiconductor layer includes a semiconductor material; and
a bonding material between the support structure and the semiconductor layer,
wherein the bonding material includes silicon, nitrogen, and oxygen.

2. The IC device according to claim 1, wherein the bonding material further includes carbon.

3. The IC device according to any one of the preceding claims, wherein a thickness of the bonding material is between about 1 and 10 nanometers.

4. The IC device according to any one of the preceding claims, wherein the semiconductor layer includes a plurality of transistors, where channel regions of the transistors include portions of the semiconductor material.

5. The IC device according to claim 4, wherein the plurality of transistors form voltage-regulator circuitry.

6. The IC device according to any one of the preceding claims, wherein:
each of the support structure and the semiconductor layer includes a first face and a second face,
the bonding material is between the second face of the support structure and the second face of the semiconductor layer, and
the IC structure further includes a plurality of vias that extend between the first face of the support structure and the first face of the semiconductor layer.

7. The IC device according to claim 6, wherein a pitch of the vias is between about 5 and 70 micrometers.

8. The IC device according to claims 6 or 7, wherein cross-sectional dimensions of the vias are between about 7 and 11 micrometers.

9. The IC device according to any one of claims 6-8, further comprising a die, coupled to the first face of the semiconductor layer by die-to-die (DTD) interconnects, wherein at least one of the vias is coupled to at least one of the DTD interconnects.

10. The IC device according to claim 9, further comprising a package substrate, coupled to the first face of the support structure by die-to-package substrate (DTPS) interconnects, wherein at least one of the vias coupled to one of the DTD interconnects is also coupled to one of the DTPS interconnects.

11. The IC device according to claim 10, wherein a pitch of the DTPS interconnects is larger than a pitch of the DTD interconnects.

12. The IC device according to any one of the preceding claims, wherein the semiconductor material includes a III-N semiconductor material.

13. The IC device according to any one of the preceding claims, wherein the semiconductor material includes germanium.

14. The IC device according to any one of the preceding claims, wherein the semiconductor material includes silicon and germanium.

15. The IC device according to any one of the preceding claims, wherein the semiconductor layer includes a plurality of portions with different semiconductor materials, wherein the semiconductor material is one of the different semiconductor materials in one of the portions, and wherein a first portion of the plurality of portions includes a III-N semiconductor material, and a second portion of the plurality of portions includes silicon germanium or germanium.
